# FASCICULE DE BREVET EUROPEEN

(11) **EP 2 617 130 B1**
(45) Date de publication et mention de la délivrance du brevet: **02.10.2019**
(21) Numéro de dépôt: 11754884.2
(22) Date de dépôt: 13.09.2011
(51) Int. Cl.: H03H 9/02, H03H 9/24

(54) **DISPOSITIF RESONANT, A DETECTION PIEZORESISTIVE ET A RESONATEUR RELIE DE FACON ELASTIQUE AU SUPPORT DU DISPOSITIF, ET PROCEDE DE FABRICATION DE CELUI-CI**
RESONANTER PIEZORESISTIVER DETEKTOR MIT EINEM AN DAS TRÄGERELEMENT DES DETEKTORS ELASTISCH ANGESCHLOSSENEN RESONATOR UND VERFAHREN ZUR HERSTELLUNG DIESES DETEKTORS
RESONANT PIEZORESISTIVE DETECTOR HAVING A RESONATOR CONNECTED ELASTICALLY TO THE SUPPORTING MEMBER OF THE DETECTOR, AND PROCESS FOR MANUFACTURING SAID DETECTOR

(30) Priorité: 13.09.2010 FR 1057251
(43) Date de publication de la demande: 24.07.2013
(73) Titulaire: Commissariat à l'Énergie Atomique et aux Énergies Alternatives, 75015 Paris (FR)
(72) Inventeur: HENTZ, Sébastien, F-38000 Grenoble (FR)
(74) Mandataire: Ilgart, Jean-Christophe
(86) Numéro de dépôt international: PCT/EP2011/065809
(87) Numéro de publication internationale: WO 2012/034990

(56) Documents cités:
- WO-A1-2009/066203
- WO-A1-2010/015963
- US-A1- 2008 314 148
- US-A1- 2009 153 267
- US-A1- 2010 186 506
- MILE E ET AL: "In-plane nanoelectromechanical resonators based on silicon nanowire piezoresistive detection", NANOTECHNOLOGY, IOP, BRISTOL, GB, vol. 21, no. 16, 23 avril 2010 (2010-04-23), page 165504, XP020174814, ISSN: 0957-4484 cité dans la demande

## Description

### DOMAINE TECHNIQUE

La présente invention concerne un dispositif résonant, à détection piézorésistive, ainsi qu'un procédé de fabrication du dispositif.

L'invention trouve des applications notamment dans le domaine des oscillateurs pour bases de temps et dans le domaine des capteurs de type MEMS (pour « Micro-Electro-Mechanical Systems ») ou de type NEMS (pour « Nano-Electro-Mechanichal Systems »).

Elle s'applique par exemple aux capteurs résonants, en particulier aux capteurs de masse.

### ÉTAT DE LA TECHNIQUE ANTÉRIEURE

Pour toutes ces applications, les performances (par exemple la résolution en masse), dépendent de la stabilité de la fréquence du résonateur que comporte le dispositif et sont proportionnelles au rapport signal sur bruit qui est noté SNR.

En considérant le déplacement du résonateur, on peut exprimer SNR comme le rapport P₀/S_{X}. Dans ce dernier, S_{X} est la densité spectrale de bruit et P₀ la puissance de la porteuse, qui est égale à la moitié du carré de l'amplitude A de vibration du résonateur.

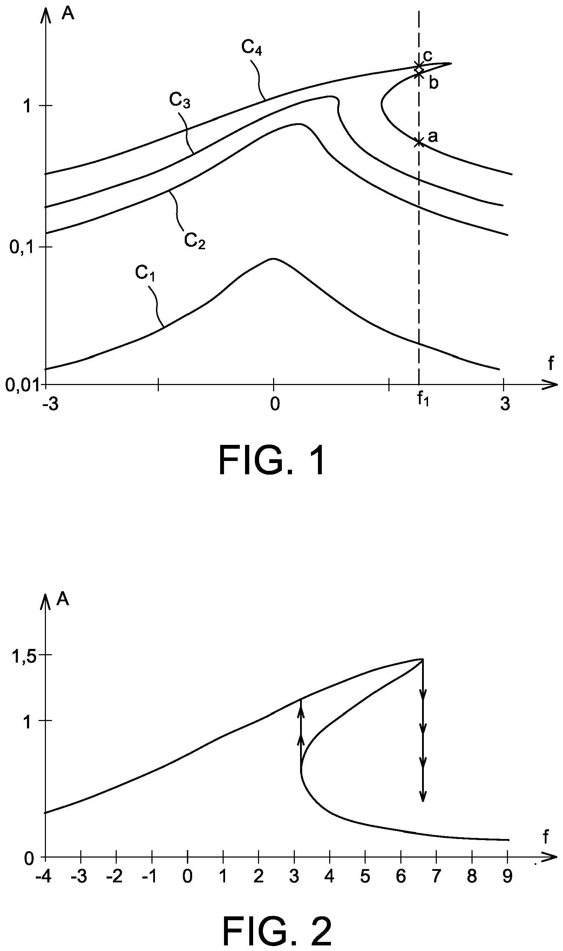

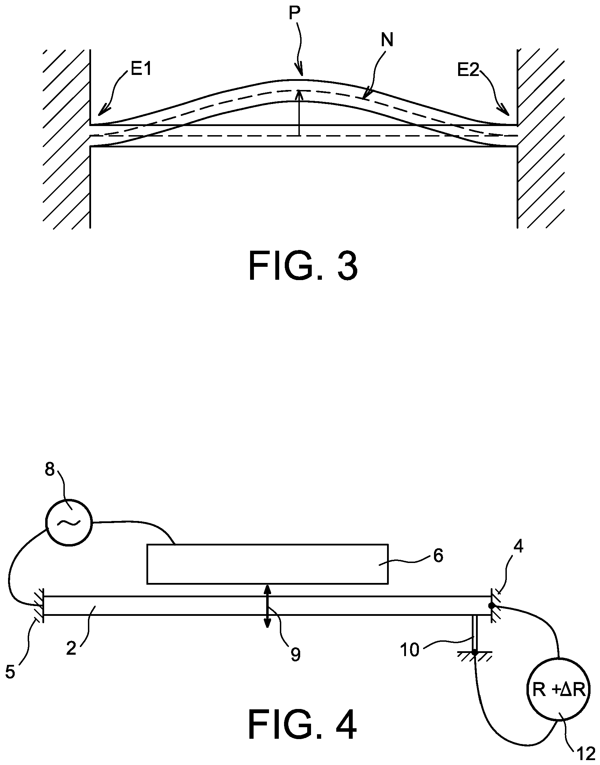

Pour améliorer les performances du résonateur, on cherche donc (1) à obtenir la plus grande amplitude de vibration possible, et (2) à réduire le bruit de sortie du dispositif.
(1) Considérons d'abord l'obtention d'une grande amplitude de vibration.
   L'homme du métier limite toujours cette amplitude à une valeur inférieure à une amplitude dite critique, notée A_{c}, au-delà de laquelle le régime de vibration devient non linéaire.
   L'apparition de ce régime non linéaire est illustrée par figure 1. Sur cette figure, on a tracé quelques courbes C₁, C₂, C₃ et C₄ représentatives de l'évolution de l'amplitude A (en unités arbitraires) en fonction de la fréquence f ou de l'écart de celle-ci par rapport à la fréquence de résonance.
   On voit que les courbes C₁ et C₂ traduisent un régime linéaire. Au contraire, lorsque l'amplitude augmente, des phénomènes non linéaires apparaissent, ce qui est le cas pour les courbes C₃ et C₄.
   Cette non linéarité se traduit par plusieurs amplitudes possibles pour certaines fréquences telles que la fréquence f1. Par exemple, la parallèle à l'axe des ordonnées, qui passe par la fréquence f1, coupe la courbe C₄ en plusieurs points a, b, et c.
   Autrement dit, dans ce régime non linéaire, le résonateur n'est plus stable. Dans une certaine zone de ce régime, trois amplitudes sont possibles pour une fréquence f₁ donnée. Le résonateur peut donc « sauter » brutalement d'une amplitude à une autre quand il est actionné en boucle ouverte à une certaine fréquence.
   L'amplitude prise par le résonateur dépend en outre des conditions initiales et des perturbations extérieures. Le résonateur devient alors difficilement contrôlable.
   Par conséquent, lorsqu'on balaye la gamme de fréquences de manière montante ou descendante, on peut observer des sauts brutaux d'amplitude.
   En outre le chemin suivi est différent dans un sens ou dans l'autre : on observe une hystérésis qui est particulièrement visible sur le schéma de la figure 2 : suivant le sens dans lequel la fréquence varie, l'évolution de l'amplitude n'est pas la même.
   L'apparition d'un régime non linéaire est en outre liée à une dégradation du bruit. En effet, du bruit (à basse ou haute fréquence) est mélangé par la composante non linéaire du résonateur, et ramène du bruit à la fréquence d'intérêt. A ce sujet, on se reportera au document suivant :
   **[1]** V.Kaajakari et al., 20 IEEE Trans. Ultrason. Ferroelectr. Freq. Control, 52, 2322-2331 (2005).
      Ainsi, on augmente l'amplitude et donc la puissance de la porteuse ; mais on dégrade simultanément le bruit, ce qui réduit totalement l'intérêt d'accroître l'amplitude.
      Par conséquent, non seulement le système n'est pas stable en boucle ouverte, mais encore le rapport signal sur bruit est dégradé.
      La source de cette non linéarité est dite géométrique et concerne toutes les structures mécaniques. Par exemple, pour une poutre P qui est encastrée en ses deux extrémités E1 et E2 (voir la figure 3), l'effet non linéaire prépondérant est l'effet d'étirement dans le plan médian (en anglais, *mid-plane stretching*).
      Dans le domaine des grands déplacements, la longueur de la fibre neutre N de la poutre ne peut plus être considérée comme constante ; la poutre s'allonge au fur et à mesure qu'elle est actionnée en flexion à des amplitudes de plus en plus importantes.
      Ainsi, plus la poutre est actionnée à des amplitudes importantes, plus sa raideur devient importante. Ceci explique pourquoi le pic de résonance se « penche » vers les hautes fréquences.
      Pour atténuer cette source de non linéarité et donc ne pas limiter autant l'amplitude des vibrations, on peut utiliser un autre résonateur, tel qu'une poutre ayant d'autres conditions aux limites.
      On peut par exemple utiliser une poutre ayant une extrémité libre et l'autre extrémité encastrée. Pour une telle poutre, l'effet d'étirement dans le plan médian n'existe pas ; toutefois, d'autres sources de non linéarité géométrique sont présentes, à des amplitudes plus importantes.
      D'autres solutions ont été proposées, par exemple l'utilisation de dispositifs de relâchement de contrainte. A ce sujet, on se reportera au document suivant :
   **[2]** US 2002/0011117**,** invention de E. Orsier et al., correspondant à FR2808264.
(2) Considérons à présent la diminution du bruit de sortie du dispositif.
   Il s'agit là d'augmenter le gain de transduction du dispositif, c'est-à-dire le rapport de l'amplitude du signal électrique de sortie du dispositif à l'amplitude de vibration du résonateur.
   Aux échelles nanométriques, la question du choix de la transduction (notamment parmi les transductions capacitive, piézoélectrique et piézorésistive) reste ouverte. Néanmoins d'excellents gains ont été obtenus avec la transduction piézorésistive, que cette dernière utilise un matériau métallique ou un matériau semiconducteur.
   Pour ce qui concerne ce dernier matériau, on peut se reporter au document suivant :
   **[3]** E. Mile et al., Nanotechnology, Vol. 21 Issue 16, pp. 165504 (2010).
      On peut par exemple utiliser une transduction piézorésistive par jauge de contrainte suspendue, alliée à une amplification mécanique de l'effort à l'aide d'un bras de levier. A ce sujet, on se reportera au document suivant :
   **[4]** US 2008/0314148**,** invention de P. Robert, correspondant à EP 2008965.

La figure 4 est une vue de dessus schématique d'un exemple du dispositif résonant, à détection piézorésistive, qui est décrit dans ce document. Il est formé sur un substrat et comprend :
- un résonateur 2, en forme de poutre, relié au substrat par au moins un encastrement 4 (en fait, dans l'exemple représenté, un deuxième encastrement 5 est prévu, comme on le voit),
- une électrode fixe 6 pour actionner le résonateur,
- une source de tension alternative 8, pour porter l'électrode à une tension alternative par rapport au résonateur, ce dernier vibrant alors parallèlement au plan de la surface du substrat, ce qui est symbolisé par la double flèche 9 de la figure 4,
- une jauge de contrainte suspendue 10, faite d'un matériau piézorésistif, et
- des moyens 12 de mesure de la contrainte subie par la jauge 10, ou jauge piézorésistive.

Cette dernière est reliée au résonateur 2 en un point qui est situé en dehors de l'encastrement 4. On dispose ainsi d'un bras de levier qui permet d'augmenter la contrainte subie par cette jauge.

Une telle solution est applicable à de nombreux dispositifs dans lesquels le résonateur est relié au substrat par au moins un encastrement à proximité de la jauge de contrainte, en particulier lorsque le résonateur est une poutre encastrée libre.

Le document [3] décrit une telle structure ainsi que des moyens d'actionnement et un schéma du montage utilisé pour détecter le mouvement du résonateur.

Dans le dispositif qui est décrit dans le document [4], la poutre formant le résonateur comprend, comme on vient de le voir, au moins un encastrement qui la relie au substrat. Ceci pose un problème.

En effet, une partie de la contrainte amplifiée par le bras de levier (résultant de la distance entre l'encastrement et le point en lequel la jauge de contrainte est reliée à la poutre) est perdue dans l'encastrement, alors qu'on souhaite évidemment maximiser la contrainte subie par la jauge piézorésistive, ou par les jauges piézorésistives lorsque le dispositif comporte plus d'une telle jauge.

De plus, l'une des sources d'amortissement du mouvement de la poutre résulte de cette perte de contrainte dans l'encastrement ; le facteur de qualité du dispositif résonant dont il est question dans le document [4] est ainsi dégradé.

En outre, pour certaine applications, il peut être nécessaire d'utiliser des résonateurs dont les conditions aux limites sont symétriques, en particulier des résonateurs dont les deux extrémités sont encastrées, par opposition à des résonateurs dont les conditions aux limites sont différentes aux deux extrémité, par exemple des résonateurs dont une extrémité est encastrée tandis que l'autre est libre.

Mais la limite de l'amplitude de vibration, qui est fixée par l'apparition du comportement non linéaire (voir plus haut), peut empêcher d'atteindre les performances souhaitées. C'est par exemple le cas pour la spectrométrie de masse à base de NEMS.

### EXPOSÉ DE L'INVENTION

La présente invention a pour objet un dispositif résonant, comportant un résonateur et des moyens de détection du déplacement du résonateur, ces moyens de détection comportant au moins une jauge piézorésistive.

Dans ce dispositif, le résonateur est susceptible d'avoir une amplitude de vibration élevée, c'est-à-dire d'avoir un régime de vibration qui reste linéaire dans un domaine d'amplitudes très étendu, tout en permettant l'utilisation de conditions aux limites symétriques, c'est-à-dire identiques aux deux extrémités du résonateur, et en minimisant la perte de contrainte dans un ancrage.

Pour ce faire, le résonateur est ancré au support, vis-à-vis duquel il est suspendu, par l'intermédiaire d'au moins un élément qui est élastique en flexion.

De plus, dans un mode de réalisation préféré du dispositif, la densité spectrale de bruit Sₓ, et donc le bruit de sortie, sont faibles ; en d'autres termes, le gain de transduction du dispositif est élevé.

Pour obtenir ce résultat, un bras de levier est prévu pour amplifier l'effort subi par la jauge piézorésistive.

De façon précise, la présente invention a pour objet un dispositif résonant, à détection piézorésistive, le dispositif comprenant :
- un support ayant une surface sensiblement plane,
- un résonateur qui est suspendu vis-à-vis du support et apte à se déplacer parallèlement au plan de la surface du support,
- des moyens d'actionnement du résonateur, et
- des moyens de détection du déplacement du résonateur, comprenant au moins une jauge de contrainte piézorésistive qui est suspendue vis-à-vis du support, comprenant en outre au moins un élément élastique différent de ladite jauge de contrainte piézorésistive, par l'intermédiaire duquel le résonateur est ancré au support, et où le résonateur et l'élément élastique comportent un matériau apte à conduire le courant électrique, caractérisé en ce que l'élément est élastique en flexion, pour permettre de repousser le seuil d'apparition d'un régime non linéaire de déplacement du résonateur.

Certes le document WO 2010/015963 décrit un transducteur électromécanique comprenant une poutre formant un résonateur qui est suspendu à un support par l'intermédiaire de deux jauges de contrainte. Mais ces jauges sont seulement élastiques selon leurs axes respectifs.

Au contraire, dans le dispositif, objet de l'invention, en plus d'une ou plusieurs jauges de contrainte, on utilise au moins un élément élastique en flexion, par l'intermédiaire duquel le résonateur est ancré au support. Cet élément permet de repousser le seuil d'apparition des non-linéarités. Un tel élément élastique en flexion permet une plus grande liberté de mouvement au résonateur : par exemple, lorsque ce dernier a la forme d'une poutre, l'élément lui confère une liberté de mouvement selon son axe (direction longitudinale) et en rotation (autour d'un axe perpendiculaire au plan des figures de la présente demande).

Un élément rectiligne, offrant une faible rigidité en flexion dans le plan du support, convient. Il suffit alors que l'élément ait un grand rapport d'aspect (rapport de sa longueur à sa largeur), par exemple supérieur à 10.

Selon un mode de réalisation particulier de l'invention, la jauge de contrainte piézorésistive comprend un empilement comportant au moins un matériau piézorésistif.

Selon un mode de réalisation préféré du dispositif, objet de l'invention, la jauge de contrainte et l'élément élastique sont sensiblement rectilignes et ne sont pas dans le prolongement l'un de l'autre.

On obtient ainsi le bras de levier mentionné plus haut, qui permet d'amplifier l'effort subi par la jauge piézorésistive.

Selon un mode de réalisation particulier du dispositif, objet de l'invention, le résonateur est en forme de poutre, et la jauge de contrainte et l'élément élastique sont respectivement situés sur deux faces latérales opposées de cette poutre.

Selon un autre mode de réalisation particulier, le dispositif comprend deux jauges de contrainte sensiblement rectilignes, le résonateur est en forme de poutre, les deux jauges de contrainte sont respectivement situées dans le prolongement l'une de l'autre, sur deux faces latérales opposées de la poutre, et l'élément élastique est situé sur l'une des faces latérales.

Selon un autre mode de réalisation particulier, le résonateur est en forme de poutre, et l'élément élastique est situé à une extrémité de la poutre et forme avec cette dernière un angle supérieur ou égal à zéro et inférieur à 90°.

Selon un autre mode de réalisation particulier, le dispositif comprend deux jauges de contrainte sensiblement rectilignes, le résonateur est en forme de diapason, comprenant deux poutres sensiblement parallèles et une liaison élastique entre les deux poutres, l'élément élastique est situé au niveau de la liaison élastique, et les deux jauges de contraintes sont respectivement situées dans le prolongement l'une de l'autre, sur les deux poutres du diapason.

Selon un autre mode de réalisation particulier, le dispositif comprend deux éléments élastiques en flexion qui sont sensiblement rectilignes, le résonateur est en forme de poutre, les deux extrémités de la poutre sont aptes à se déplacer parallèlement au plan de la surface du support, et les deux éléments élastiques sont respectivement situés à l'une des extrémités de la poutre, sur deux faces latérales opposées de celle-ci.

Dans ce cas, le dispositif peut comprendre deux autres éléments élastiques en flexion qui sont sensiblement rectilignes et sont respectivement situés à l'autre extrémité de la poutre, sur les deux faces latérales opposées de celle-ci.

Selon un autre mode de réalisation particulier, le dispositif comprend au moins deux jauges de contrainte, au moins l'une de ces jauges de contrainte est élastique en flexion, et l'élément élastique en flexion est constitué par la jauge de contrainte élastique en flexion.

La présente invention concerne aussi un procédé de fabrication du dispositif, objet de l'invention, dans lequel on forme le résonateur, chaque jauge de contrainte et chaque élément élastique par une technologie de surface.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 montre des courbes représentatives de l'évolution de l'amplitude en fonction de la fréquence, pour le résonateur d'un dispositif résonant connu, et a déjà été décrite,
- la figure 2 illustre schématiquement un phénomène d'hystérésis qui peut affecter un tel dispositif, et a déjà été décrite,
- la figure 3 illustre schématiquement l'allongement d'une poutre encastrée en ses deux extrémités, au fur et à mesure que cette poutre est actionnée en flexion à des amplitudes de plus en plus importantes, et a déjà été décrite,
- la figure 4 est une vue de dessus schématique d'un dispositif résonant connu, à détection piézorésistive, et a déjà été décrite,
- la figure 5 est une vue de dessus schématique d'un mode de réalisation particulier du dispositif, objet de l'invention,
- les figures 6 à 9 sont des vues de dessus schématiques d'autres modes de réalisation particuliers de ce dispositif,
- la figure 10 est une vue de dessus schématique d'un exemple de l'invention, dans lequel le résonateur a la forme d'un diapason,
- les figures 11 à 13 sont des vues de dessus schématiques d'autres exemples de l'invention, dans lesquels le résonateur a la forme d'une poutre dont les deux extrémités sont libres,
- les figures 14A à 14C illustrent schématiquement diverses étapes d'un procédé de fabrication d'un dispositif conforme à l'invention, et
- les figures 15A à 15D illustrent schématiquement diverses étapes d'un autre procédé de fabrication d'un dispositif conforme à l'invention.

### EXPOSÉ DÉTAILLÉ DE MODES DE RÉALISATION PARTICULIERS

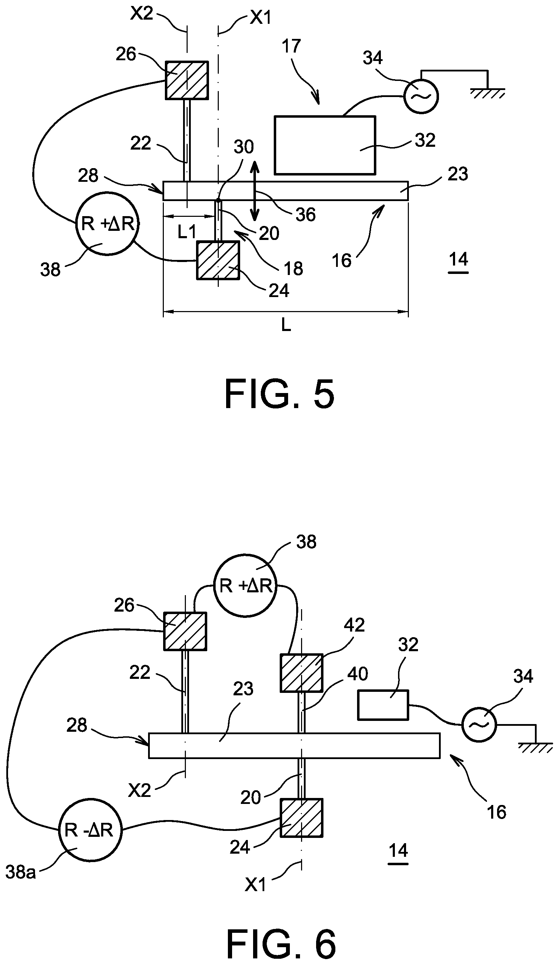

La figure 5 est une vue de dessus schématique d'un mode de réalisation particulier du dispositif résonant, objet de l'invention.

Le dispositif représenté sur cette figure comprend :
- un support 14, ou substrat, dont la surface est sensiblement plane,
- un résonateur 16 qui est suspendu vis-à-vis du support 14 - on dit aussi qu'il est libéré du support - et qui est apte à se déplacer parallèlement au plan de la surface du support,
- des moyens 17 d'actionnement du résonateur 16, et
- des moyens 18 de détection du déplacement du résonateur 16.

Dans l'exemple représenté sur la figure 5, ces moyens de détection 18 comprennent une seule jauge de contrainte piézorésistive 20. Cette jauge est en forme de poutre et elle est donc sensiblement rectiligne. De plus, elle est suspendue vis-à-vis du support 14 - elle est libérée de ce dernier. Cette jauge peut être faite d'un matériau piézorésistif ou peut comprendre un empilement comportant au moins un matériau piézorésistif.

Conformément à l'invention, le résonateur n'est pas directement ancré au support 14 : le dispositif représenté sur la figure 5 comprend en outre un élément élastique 22 par l'intermédiaire duquel le résonateur est ancré au support 14. Cela permet de repousser le seuil d'apparition d'un régime non linéaire de déplacement du résonateur.

Dans l'exemple représenté sur la figure 5, le résonateur 16 est en forme de poutre. L'élément élastique 22 est également en forme de poutre et il est donc sensiblement rectiligne, comme la jauge de contrainte 20, ou jauge piézorésistive.

Mais cette jauge 20 et l'élément élastique 22 ne sont pas dans le prolongement l'un de l'autre : comme on le voit, leurs axes respectifs X1 et X2 sont espacés l'un de l'autre. De plus, la jauge 20 et l'élément 22 sont respectivement situés sur deux faces latérales opposées de la poutre 23 formant le résonateur.

Les moyens de détection comprennent des ancrages 24 et 26 par l'intermédiaire desquels la jauge 20 et l'élément 22 sont respectivement fixés au support 14.

Dans l'exemple représenté sur la figure 5, la jauge 20 et l'élément 22 sont tous deux disposés perpendiculairement à la poutre 23 (et parallèlement à la surface du support 14) ; une extrémité de l'élément 22 se trouve au voisinage d'une extrémité 28 de la poutre 23, tandis que son autre extrémité est fixée à l'ancrage 26 ; et une extrémité de la jauge 20 se trouve en un point 30 de la poutre 23, espacé de l'extrémité 28 de celle-ci, tandis que l'autre extrémité de la jauge 20 est fixée à l'ancrage 24.

Dans cet exemple, les moyens d'actionnement 17 sont de type électrostatique et comprennent une électrode 32 qui est fixée au support 14. Une source de tension alternative 34 est prévue pour porter l'électrode 32 à une tension alternative par rapport à la poutre 23. Lorsque cette dernière est ainsi excitée, elle vibre parallèlement au plan de la surface du support 14, ce que l'on a symbolisé par la double flèche 36 sur la figure 5.

Pour exciter la résonance de la poutre 23, on peut utiliser d'autres moyens que des moyens électrostatiques, par exemple des moyens piézoélectriques, thermiques ou électromagnétiques.

L'élément 22, ou poutre de suspension, est libéré ; de plus, il est préférable que son élancement, c'est-à-dire le rapport de sa longueur à sa largeur soit important, par exemple supérieur à 5 mais de préférence supérieur à 10. L'élément 22 n'oppose alors que très peu de résistance au mouvement de la poutre 23, et maximise la contrainte que subit la jauge piézorésistive 20.

En effet, compte tenu de l'élancement de l'élément 22 :
- d'une part, la raideur en traction-compression de cet élément 22 sur son axe X2 est très grande ; on profite donc de l'effet de bras de levier et de l'amplification de l'effort exercé sur la jauge (il est préférable que la distance (non nulle) entre l'axe X1 de la jauge 20 et l'axe X2 de la poutre de suspension 22 soit faible, par exemple inférieure au tiers de la longueur de la poutre 23,
- mais, d'autre part, la raideur en flexion de l'élément 22 est faible ; donc cet élément « résiste » très peu au mouvement de flexion transversale de la poutre 23.

Les dimensions de la jauge piézorésistive doivent être choisies afin d'aboutir au meilleur compromis possible entre le bruit de Johnson engendré par cette jauge - ce bruit est proportionnel à la résistance de la jauge - et la contrainte subie par cette dernière, contrainte qui est inversement proportionnelle à la section transversale de la jauge.

On choisit donc, au premier ordre, une jauge qui est très courte et dont la section transversale est aussi faible que possible.

La position relative de la jauge est également choisie afin de maximiser les contraintes subies par la jauge. Cette position dépend donc du mode propre de fonctionnement choisi.

Par exemple, dans le cas de la figure 5, pour le mode de résonance appelé « mode 1 », on peut estimer que la position optimale est telle que la distance L1 entre l'extrémité 28 de la poutre 23 et le point 30 soit de l'ordre de 10% de la longueur L de la poutre 23.

La différence de conception entre le dispositif, objet de l'invention, par exemple le dispositif représenté sur la figure 5, et le dispositif qui est décrit dans le document [4], ne change rien à la méthode de lecture du dispositif : dans la présente invention, il s'agit toujours de lire la variation de la résistance d'une ou plusieurs jauges piézorésistives.

Dans la présente invention, bien qu'on ait modifié la structure mécanique, cette lecture est tout de même possible en connectant des moyens de lecture 38 entre les ancrages respectifs 24 et 26 de la jauge 20 et de l'élément 22.

Ces ancrages 24 et 26 sont alors faits d'un matériau électriquement conducteur. Il en est d'ailleurs de même dans tous les exemples donnés par la suite, pour les deux ancrages entre lesquels on connecte les moyens de lecture.

Et bien entendu, dans tous les exemples, le résonateur et chaque élément élastique utilisé pour la lecture (l'élément 22 dans le cas de la figure 5) sont également faits d'un matériau apte à conduire le courant électrique, par exemple d'un matériau piézorésistif.

On lit donc la variation de résistance de la jauge 20, de façon classique, entre les deux ancrages servant de connexions électriques. Cette lecture peut être faite :
- de façon directe,
- ou à l'aide d'un amplificateur synchrone (en anglais, *lock-in amplifier*),
- ou à l'aide d'un pont de Wheatstone (voir le document [4]),
- ou par une technique plus sophistiquée, comme cela est expliqué dans le document [3] auquel on se reportera.

En revanche, la variation de résistance, lue par cette méthode, inclut la variation de résistance de la poutre de suspension 22, si cette dernière est également faite d'un matériau piézorésistif.

Il faut donc s'assurer que la variation de résistance de la poutre de suspension 22 est négligeable par rapport à la variation « utile » de résistance de la jauge 20. Pour ce faire, il est par exemple possible :
- de donner à la poutre de suspension 22 une section transversale supérieure à celle que l'on donne à la jauge 20,
- ou de doper localement la poutre de suspension 22 afin de diminuer sa résistance et son facteur de jauge,
- ou encore de faire en sorte que ces variations respectives de résistance soient de même signe, en plaçant la jauge 20 et la poutre de suspension 22 de part et d'autre de la poutre 23 constituant le résonateur, ce qui est le cas dans l'exemple représenté sur la figure 5.

On peut également utiliser deux jauges piézorésistives sensiblement rectilignes dont les axes respectifs sont confondus et qui sont décalées par rapport à la poutre de suspension. Cela permet une lecture différentielle si les jauges sont disposées de part et d'autre du résonateur.

L'exemple de la figure 6 illustre schématiquement cette possibilité. Le dispositif représenté sur cette figure se distingue de celui de la figure 5 par le fait qu'il comprend une autre jauge piézorésistive sensiblement rectiligne 40 dont l'ancrage a la référence 42. Comme on le voit, les jauges 20 et 40 sont situées sur deux faces latérales opposées de la poutre 23 et ont le même axe X1.

Dans le cas de la figure 6, on utilise une lecture différentielle : les moyens de lecture comportent un premier moyen de lecture 38 qui est connecté entre les ancrages 26 et 42 et permet de déterminer la valeur R+ΔR de la résistance de la jauge 40, et un deuxième moyen de lecture 38a qui est connecté entre les ancrages 26 et 24 et permet de déterminer la valeur R-ΔR de la résistance de la jauge 20.

On peut également utiliser deux poutres de suspension. Alors, la raideur globale est augmentée mais la résistance d'accès du dispositif est diminuée si l'on connecte électriquement les deux poutres de suspension : ces dernières constituent alors deux résistances montées en parallèle.

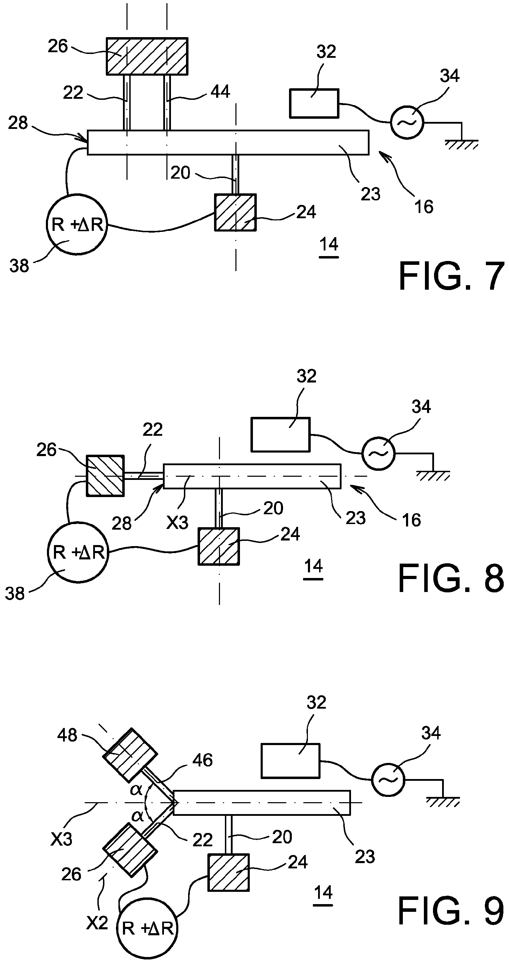

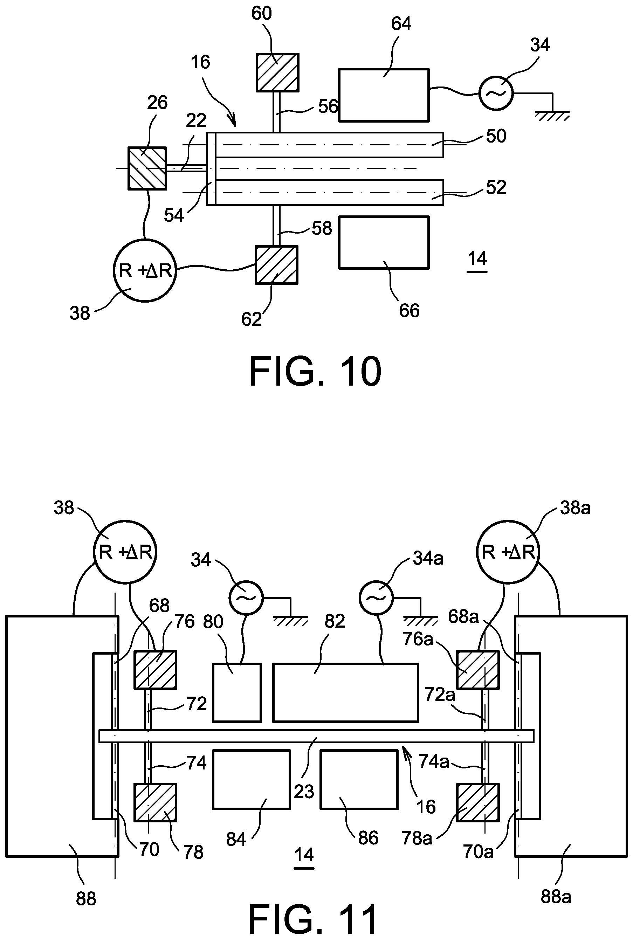

Ceci est schématiquement illustré par la figure 7. Le dispositif représenté sur cette figure se distingue de celui qui est représenté sur la figure 5 par le fait qu'il comprend une autre poutre de suspension 44. Comme on le voit, les deux poutres de suspension 22 et 44, constituant deux éléments élastiques en flexion, sont d'un même côté de la poutre 16 et ont un ancrage commun 26 (voir aussi un autre exemple sur la figure 11 qui sera décrite ultérieurement).

Les deux poutres de suspension peuvent, ou non, se situer à l'une des deux extrémités de la poutre formant le résonateur, et l'on peut même prévoir deux autres poutres de suspension, connectées en parallèle, à l'autre extrémité du résonateur (voir aussi la figure 11) .

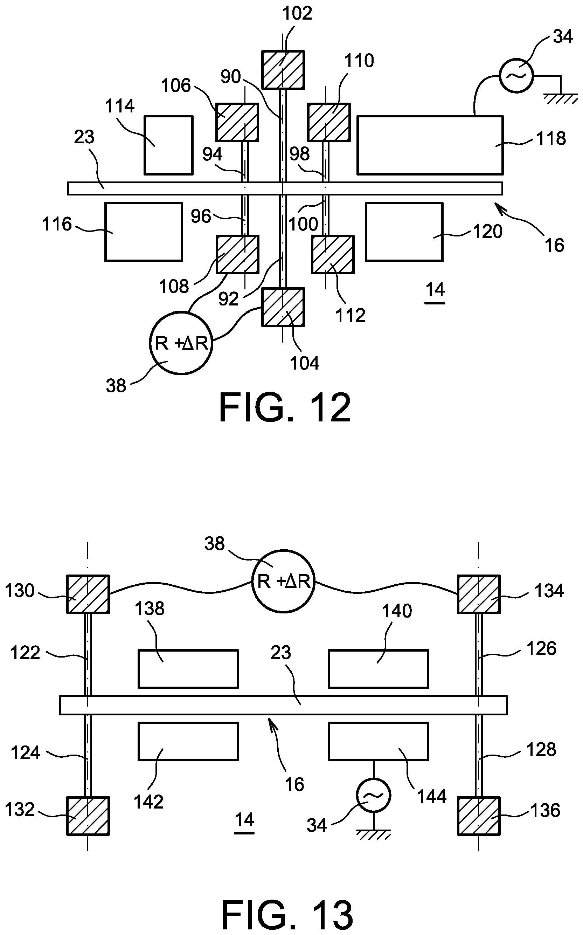

Quant aux jauges piézorésistives, contrairement au cas de la figure 6, elles peuvent être disposées entre l'extrémité 28 du résonateur 16 et la poutre de suspension 22 (voir la figure 12 qui sera décrite ultérieurement).

On peut également placer l'élément élastique (libéré), en forme de poutre, (a) dans l'axe du résonateur en forme de poutre ou (b) suivant un axe différent.

Dans ce dernier cas (b), on favorise peu le déplacement suivant l'axe du résonateur ; donc l'amplitude de vibration est peu augmentée avant l'apparition du régime non linéaire ; en revanche, on minimise la contrainte récupérée par l'ancrage 26 associé à l'élément élastique 22 et l'on maximise la contrainte subie par la jauge 20.

Les deux cas (a) et (b) sont schématiquement illustrés par les figures 8 et 9.

L'exemple de la figure 8 se distingue de celui de la figure 5 par le fait que, dans le cas de la figure 8, l'élément élastique 22 en forme de poutre est fixé à l'extrémité 28 de la poutre 23 et s'étend suivant l'axe X3 de cette dernière.

Dans l'exemple de la figure 9, l'élément élastique 22 en forme de poutre est encore fixé à l'extrémité 28 de la poutre 23 mais l'axe X2 de cet élément fait un angle α avec l'axe X3 de la poutre 23, tel que : 0<α<90° (alors que α est nul dans le cas de la figure 8).

La figure 9 illustre également la possibilité de prévoir un autre élément élastique en flexion 46, en forme de poutre, à l'extrémité 28 de la poutre 23. L'ancrage qui lui est associé a la référence 48 et l'axe X4 de l'élément 46 est incliné par rapport à l'axe X3. Dans l'exemple de la figure 9, les éléments 22 et 46 sont symétriques l'un de l'autre par rapport à l'axe X3.

Comme dans certains des exemples mentionnés plus haut, les éléments 22 et 46 peuvent avoir le même ancrage et constituent alors des résistances en parallèle.

Dans un autre exemple de l'invention, schématiquement illustré par la figure 10, le résonateur 16 est en forme de diapason. Il comprend deux poutres parallèles 50 et 52 et une liaison élastique 54 entre deux extrémités respectives des poutres, comme on le voit.

L'élément élastique 22, en forme de poutre, est situé au niveau de la liaison élastique 54 ; il s'étend de préférence parallèlement aux axes (parallèles) des poutres 50 et 52.

Deux jauges piézorésistives, sensiblement rectilignes 56 et 58 sont situées dans le prolongement l'une de l'autre (leurs axes respectifs sont confondus), respectivement sur les deux poutres 50 et 52. Les ancrages des jauges 56 et 58 ont les références respectives 60 et 62.

Deux électrodes 64 et 66, prévues pour actionner le diapason, sont respectivement disposées en regard des poutres 50 et 52, comme on le voit.

Dans l'exemple représenté sur la figure 10, les moyens de lecture 38 sont connectés entre les ancrages 26 et 62, et la source 34 excite l'électrode 64. Toutefois, il est également possible d'exciter simultanément les deux électrodes 64 et 66 avec la source 34.

Dans l'exemple de l'invention qui est schématiquement illustré par la figure 11, la poutre 23 utilisée en tant que résonateur a des conditions aux limites symétriques : ses deux extrémités sont aptes à se déplacer parallèlement à la surface du support 14.

Deux éléments élastiques en flexion, sensiblement rectilignes 68 et 70 sont respectivement situés au voisinage de l'une des extrémités de la poutre 23, sur deux faces latérales opposées de celle-ci ; et ces éléments 68 et 70 sont dans le prolongement l'un de l'autre : leurs axes respectifs sont confondus.

Deux jauges piézorésistives 72 et 74 sont situées sur les deux faces latérales opposées de la poutre 23 et leurs axes respectifs sont également confondus. Les ancrages des jauges 72 et 74 ont les références respectives 76 et 78.

On peut prévoir plusieurs électrodes d'excitation. Dans l'exemple représenté, il y en a quatre qui ont les références respectives 80, 82, 84 et 86. Les électrodes 80 et 82 sont en regard de l'une des faces latérales de la poutre 23, et les électrodes 84 et 86 sont en regard de son autre face latérale.

Dans l'exemple de la figure 11, on excite simplement l'électrode 80 au moyen de la source 34 ; et les moyens de lecture sont connectés entre l'ancrage 76, associé à la jauge piézorésistive 72, et un ancrage 88 qui est commun aux éléments élastiques 68 et 70 ; ces derniers forment alors des résistances montées en parallèle.

En variante, on prévoit un ensemble identique de composants, du côté de l'autre extrémité de la poutre 23 ; les références homologues sont affectées de la lettre a.

Sur la figure 11, on voit ainsi des éléments élastiques en flexion 68a et 70a, des jauges piézorésistives 72a et 74a, des ancrages 76a et 78a, un ancrage commun 88a, une source 34a qui excite l'électrode 82, et des moyens de lecture 38a connectés entre l'ancrage 76a et l'ancrage 88a.

La configuration illustrée par la figure 11, dans laquelle les deux extrémités de la poutre 23 sont libres, présente divers avantages qui sont mentionnés ci-après.
1. Cette configuration permet toujours la lecture de la variation de résistance des jauges.
2. Elle utilise des conditions aux limites symétriques, mais permet dans le même temps des amplitudes de vibration linéaires importantes.
   En effet, les poutres de suspension formant les éléments élastiques présentent, de préférence, un élancement important ; elles ont alors une faible raideur en flexion et le résonateur n'est donc pas contraint sur son axe. Il est libre de s'allonger quand l'amplitude de vibration augmente.
   Alors, l'effet d'étirement dans le plan médian est tout à fait réduit et l'amplitude de vibration utile devient comparable à celle d'un résonateur de type encastré-libre.
3. A chaque extrémité de la poutre 23, les deux poutres de suspension ont un ancrage commun et sont donc électriquement reliées. Comme on l'a vu, elles sont ainsi équivalentes à deux résistances en parallèle dont la résistance équivalente vaut la moitié de celle d'une seule poutre de suspension.
   De plus, lorsque l'une des deux poutres de suspension est contrainte en compression, l'autre est contrainte en tension. Par conséquent, la somme de leurs variations de résistance est nulle. Ainsi, la configuration de la figure 11 permet de ne lire que la variation utile de résistance des jauges, et de s'affranchir de celle des poutres de suspension.
4. Comme on l'a vu, on peut utiliser la même disposition pour les jauges et les poutres de suspension à l'autre extrémité du résonateur (conditions aux limites symétriques). Cela permet d'utiliser un autre ancrage, constituant un port de détection, soit pour obtenir un signal deux fois plus important, soit pour faire résonner la structure simultanément sur deux modes.
5. Comme dans tous les autres cas, on peut utiliser une ou plusieurs électrodes d'actionnement électrostatique. Cela permet de favoriser certains modes privilégiés de la structure, voire de découpler deux harmoniques d'actionnement à des fréquences différentes.

Dans l'exemple qui est schématiquement illustré par la figure 12, les jauges piézorésistives et les poutres de suspension sont placées au milieu du résonateur.

Comme on le voit, dans cet exemple, la poutre 23, formant le résonateur, est pourvue de deux éléments sensiblement rectilignes 90 et 92 qui sont élastiques en flexion et sont situés de part et d'autre de la poutre 23, au milieu de celle-ci, et dont les axes respectifs sont confondus.

D'un côté de ces éléments, deux jauges piézorésistives 94 et 96 sont disposées de part et d'autre de la poutre 23 et leurs axes respectifs sont confondus. De l'autre côté des éléments 90 et 92, deux autres jauges piézorésistives 98 et 100 sont également disposées de part et d'autre de la poutre 23 et ont des axes respectifs confondus.

Les ancrages des éléments 90 et 92 et des jauges 94, 96, 98 et 100 ont respectivement les références 102, 104, 106, 108, 110 et 112.

Dans l'exemple de la figure 12, quatre électrodes d'actionnement sont prévues, à savoir deux électrodes 114 et 116 à une extrémité de la poutre 23, de part et d'autre de celle-ci, et deux autres électrodes 118 et 120 à l'autre extrémité de la poutre 23, de part et d'autre de celle-ci.

En outre, à titre d'exemple, on excite l'électrode 118 à l'aide de la source 34, et l'on connecte les moyens de lecture 38 entre les ancrages 96 et 104.

On peut concevoir d'autres exemples de l'invention, utilisant une ou plusieurs poutres de suspension et une ou plusieurs jauges piézorésistives.

En outre, on peut concevoir un dispositif conforme de l'invention, qui comprend au moins deux jauges piézorésistives et dans lequel au moins l'une de ces jauges est élastique et constitue l'élément élastique par l'intermédiaire duquel le résonateur est ancré au support.

Un exemple d'un tel dispositif est schématiquement illustré par la figure 13.

On y voit la poutre 23 formant le résonateur, et pourvue de quatre jauges piézorésistives sensiblement rectilignes 122, 124, 126 et 128.

Les jauges 122 et 124 sont élastiques en flexion, sont disposées au voisinage de l'une des extrémités de la poutre 23, de part et d'autre de celle-ci, et ont des axes confondus. Les deux autres jauges 126 et 128, qui pourraient aussi être élastiques en flexion, sont disposées au voisinage de l'autre extrémité de la poutre 23, de part et d'autre de celle-ci, et ont également des axes confondus.

Les ancrages des jauges 122, 124, 126 et 128 ont les références respectives 130, 132, 134 et 136.

Dans l'exemple de la figure 13, quatre électrodes d'actionnement sont prévues, à savoir deux électrodes 138 et 140 disposées au voisinage du milieu de la poutre 23, en regard de l'une des faces latérales de celle-ci, et deux autres électrodes 142 et 144 disposées en regard de l'autre face latérale, et respectivement en regard des électrodes 138 et 140.

En outre, à titre d'exemple, on excite l'électrode 134 à l'aide de la source 34, et l'on connecte les moyens de lecture 38 entre les ancrages 130 et 134.

Les jauges piézorésistives utilisées dans l'invention peuvent être en silicium dopé. Elles peuvent aussi être métalliques ; pour ce faire, on peut doper très fortement le silicium jusqu'à l'amorphisation de celui-ci. On peut aussi utiliser des jauges faites d'un composé métal-silicium tel que NiSi ou PtSi par exemple.

Il est également possible d'obtenir les jauges à partir d'éléments de silicium sur lesquels on dépose une couche métallique, par exemple en or ou en aluminium, pour constituer la partie sensible des jauges.

Un dispositif conforme à l'invention peut être fabriqué par une technologie de surface.

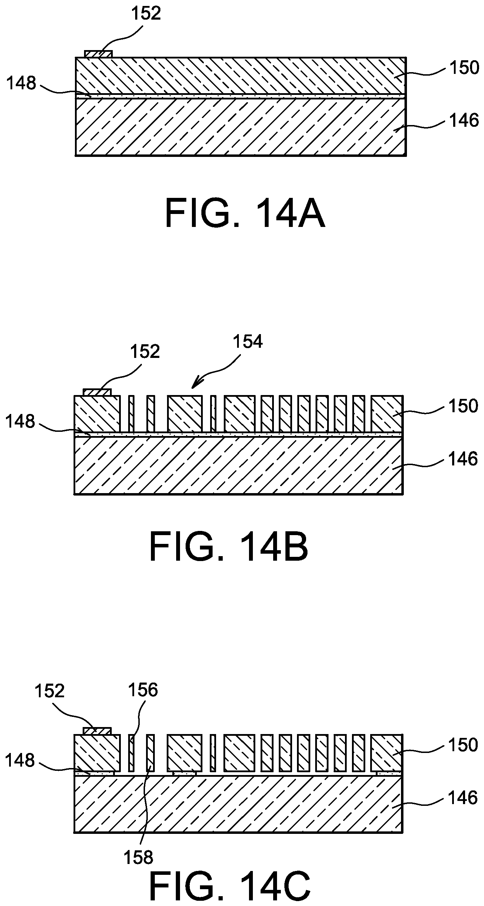

Un exemple de procédé de fabrication est schématiquement et partiellement illustré par les figures 14A à 14C.

On commence (figure 14A) par déposer une couche de Ti/Ni/Au sur un substrat SOI comprenant un substrat de base 146 en silicium, une couche sacrificielle 148 en SiO₂, dont l'épaisseur vaut par exemple 0,4 µm, et une couche de silicium 150 dont l'épaisseur vaut par exemple 4 µm. On délimite les contacts du dispositif, tels que le contact 152, par photolithographie et gravure.

On délimite ensuite (figure 14B) la structure mécanique 154 du dispositif par photolithographie et gravure DRIE (pour « Deep Reaction Ion Etching »), avec arrêt sur la couche sacrificielle 148.

On libère ensuite (figure 14C) les composants du dispositif par exposition à l'acide fluorhydrique (sous forme liquide ou gazeuse), avec arrêt au bout d'une durée déterminée.

On obtient ainsi une ou plusieurs jauges piézorésistives telles que la jauge 156, un résonateur 158, un ou plusieurs éléments élastiques (non représentés), et une ou plusieurs électrodes d'excitation (non représentées) du résonateur.

Dans ce procédé, la photolithographie peut être effectuée au moyen d'un faisceau d'électrons.

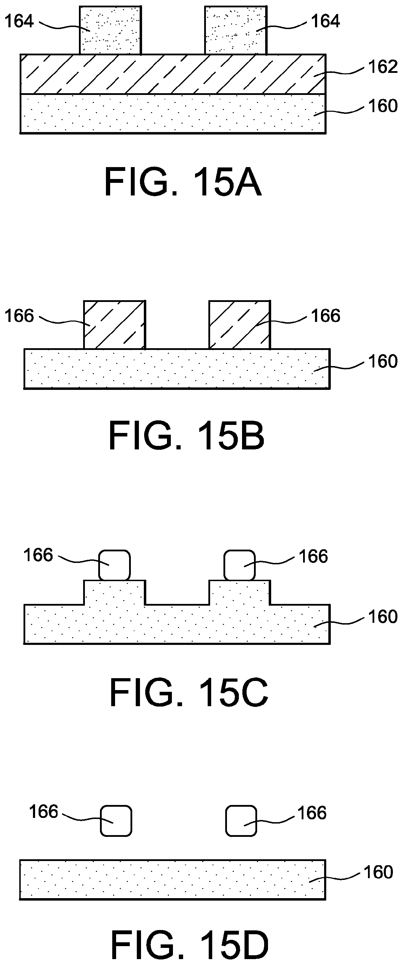

Le résonateur lui-même, mais surtout les jauges piézorésistives et les éléments élastiques peuvent être des nanofils (en anglais, *nanowires*) que l'on forme par une technologie de surface de type « top-down », conformément à un autre exemple de procédé de fabrication qui est schématiquement illustré par les figures 15A à 15D.

On commence par former une couche sacrificielle 160 (figure 15A) qui peut être en SiO₂, en SiGe ou en Si. On forme ensuite une couche active 162 sur la couche 160.

La couche 162 peut être en Si ou en SiGe. Il s'agit de la couche dans laquelle on forme les divers éléments, ou motifs, du dispositif, tels que le résonateur par exemple en forme de poutre, une ou plusieurs jauges piézorésistives et un ou plusieurs éléments élastiques.

On forme ensuite un masque de résine photosensible 164 qui est nécessaire à l'obtention des motifs.

On définit ensuite ces motifs, tels que les motifs 166 (figure 15B), par photolithographie et gravure de la couche active. Une réduction de cote de la résine (en anglais, *resist trimming*) peut être effectuée au préalable.

On procède ensuite à une oxydation puis à une désoxydation pour réduire la taille des motifs 166 et les arrondir (figure 15C).

Puis on libère les motifs 166 (figure 15D), à l'aide d'acide fluorhydrique dans le cas de SiO₂ ou à l'aide d'un plasma de type méthane-oxygène dans le cas de SiGe.

## Revendications

1. Dispositif résonant, à détection piézorésistive, le dispositif comprenant :
- un support (14) ayant une surface sensiblement plane,
- un résonateur (16) qui est suspendu vis-à-vis du support et apte à se déplacer parallèlement au plan de la surface du support,
- des moyens (17) d'actionnement du résonateur, et
- des moyens (18) de détection du déplacement du résonateur, comprenant au moins une jauge de contrainte piézorésistive (20 ; 20,40 ; 56,58 ; 72,72a,74,74a ; 94,96,98,100 ; 122,124,126,128) qui est suspendue vis-à-vis du support,
comprenant en outre au moins un élément élastique (22 ; 22,44 ; 22,46 ; 68, 68a, 70, 70a ; 90,92 ; 122,124) différent de ladite jauge de contrainte piézorésistive, par l'intermédiaire duquel le résonateur est ancré au support, et
où le résonateur et l'élément élastique comportent un matériau apte à conduire le courant électrique,
**caractérisé en ce que** l'élément est élastique en flexion, pour permettre de repousser le seuil d'apparition d'un régime non linéaire de déplacement du résonateur.

2. Dispositif selon la revendication 1, dans lequel l'élément élastique est sensiblement rectiligne et le rapport de sa longueur à sa largeur est supérieur à 5.

3. Dispositif selon la revendication 2, dans lequel le rapport est supérieur à 10.

4. Dispositif selon l'une quelconque des revendications 1 à 3, dans lequel la jauge de contrainte piézorésistive comprend un empilement comportant au moins un matériau piézorésistif.

5. Dispositif selon l'une quelconque des revendications 1 à 4, dans lequel la jauge de contrainte et l'élément élastique sont sensiblement rectilignes et ne sont pas dans le prolongement l'un de l'autre.

6. Dispositif selon la revendication 5, dans lequel le résonateur est en forme de poutre (23) et dans lequel la jauge de contrainte (20) et l'élément élastique (22) sont respectivement situés sur deux faces latérales opposées de la poutre.

7. Dispositif selon la revendication 5, comprenant deux jauges de contrainte sensiblement rectilignes (20,40), dans lequel le résonateur est en forme de poutre (23), les deux jauges de contrainte sont respectivement situées dans le prolongement l'une de l'autre, sur deux faces latérales opposées de la poutre, et l'élément élastique (22) est situé sur l'une des faces latérales.

8. Dispositif selon la revendication 5, dans lequel le résonateur est en forme de poutre (23) et l'élément élastique (22 ; 22,46) est situé à une extrémité de la poutre et forme avec cette dernière un angle supérieur ou égal à zéro et inférieur à 90°.

9. Dispositif selon la revendication 5, comprenant deux jauges de contrainte sensiblement rectilignes (56,58), dans lequel le résonateur est en forme de diapason, comprenant deux poutres sensiblement parallèles (50,52) et une liaison élastique (54) entre les deux poutres, l'élément élastique (22) est situé au niveau de la liaison élastique, et les deux jauges de contraintes sont respectivement situées dans le prolongement l'une de l'autre, sur les deux poutres du diapason.

10. Dispositif selon la revendication 5, comprenant deux éléments élastiques en flexion qui sont sensiblement rectilignes (68,70), dans lequel le résonateur est en forme de poutre (23), les deux extrémités de la poutre sont aptes à se déplacer parallèlement au plan de la surface du support (14), et les deux éléments élastiques sont respectivement situés à l'une des extrémités de la poutre, sur deux faces latérales opposées de celle-ci.

11. Dispositif selon la revendication 10, comprenant deux autres éléments élastiques en flexion qui sont sensiblement rectilignes (68a, 70a) et sont respectivement situés à l'autre extrémité de la poutre (23), sur les deux faces latérales opposées de celle-ci.

12. Dispositif selon la revendication 5, comprenant au moins deux jauges de contrainte (122,124,126,128), dans lequel au moins l'une des jauges de contrainte (122,124) est élastique en flexion, et l'élément élastique en flexion est constitué par la jauge de contrainte qui est élastique en flexion.

## Patentansprüche

1. Resonanzvorrichtung mit piezoresistiver Erfassung, wobei die Vorrichtung enthält:
- eine Halterung (14) mit einer im Wesentlichen ebenen Oberfläche,
- einen Resonator (16), der bezüglich der Halterung abgehängt und dazu geeignet ist, sich parallel zur Ebene der Oberfläche der Halterung zu verlagern,
- Mittel (17) zum Betätigen des Resonators und
- Mittel (18) zum Erfassen der Verlagerung des Resonators, enthaltend zumindest einen piezoresistiven Dehnungsmessstreifen (20; 20, 40; 56, 58; 72, 72a, 74, 74a; 94, 96, 98, 100; 122, 124, 126, 128), der bezüglich der Halterung abgehängt ist,
ferner enthaltend
zumindest ein elastisches Element (22; 22, 44; 22, 46; 68, 68a, 70, 70a; 90, 92; 122, 124), das sich von dem piezoresistiven Dehnungsmessstreifen unterscheidet und durch das der Resonator an der Halterung verankert ist, und wobei der Resonator und das elastische Element ein Material enthalten, das dazu geeignet ist, elektrischen Strom zu leiten,
**dadurch gekennzeichnet, dass**
das Element biegeelastisch ist, um zu ermöglichen, die Schwelle des Auftretens eines nichtlinearen Verlaufs der Verlagerung des Resonators zu verschieben.

2. Vorrichtung nach Anspruch 1, wobei das elastische Element im Wesentlichen geradlinig ist und das Verhältnis seiner Länge zu seiner Breite höher als 5 ist.

3. Vorrichtung nach Anspruch 2, wobei das Verhältnis höher als 10 ist.

4. Vorrichtung nach einem der Ansprüche 1 bis 3, wobei der piezoresistive Dehnungsmessstreifen eine Stapelung mit zumindest einem piezoresistiven Material enthält.

5. Vorrichtung nach einem der Ansprüche 1 bis 4, wobei der Dehnungsmessstreifen und das elastische Element im Wesentlichen geradlinig sind und nicht in Verlängerung zueinander liegen.

6. Vorrichtung nach Anspruch 5, wobei der Resonator in Balkenform (23) vorliegt und wobei der Dehnungsmessstreifen (20) und das elastische Element (22) auf zwei jeweiligen entgegengesetzten Seitenflächen des Balkens liegen.

7. Vorrichtung nach Anspruch 5, enthaltend zwei im Wesentlichen geradlinige Dehnungsmessstreifen (20, 40), wobei der Resonator in Balkenform (23) vorliegt, wobei die beiden Dehnungsmessstreifen jeweils in Verlängerung zueinander auf zwei entgegengesetzten Seitenflächen des Balkens liegen und das elastische Element (22) auf einer der Seitenflächen liegt.

8. Vorrichtung nach Anspruch 5, wobei der Resonator in Balkenform (23) vorliegt und das elastische Element (22; 22, 46) an einem Ende des Balkens liegt und mit diesem einen Winkel größer oder gleich null und kleiner als 90° einschließt.

9. Vorrichtung nach Anspruch 5, enthaltend zwei im Wesentlichen geradlinige Dehnungsmessstreifen (56, 58), wobei der Resonator in Form eines Gabel vorliegt, enthaltend zwei im Wesentlichen parallel verlaufende Balken (50, 52) und eine elastische Verbindung (54) zwischen den beiden Balken, wobei das elastische Element (22) im Bereich der elastischen Verbindung liegt und die beiden Dehnungsmessstreifen jeweils in Verlängerung zueinander auf den beiden Balken der Gabel liegen.

10. Vorrichtung nach Anspruch 5, enthaltend zwei biegeelastische Elemente, die im Wesentlichen geradlinig (68, 70) sind, wobei der Resonator in Balkenform (23) vorliegt, wobei die beiden Enden des Balkens dazu geeignet sind, sich parallel zur Ebene der Oberfläche der Halterung (14) zu verlagern, und die beiden elastischen Elemente jeweils an einem der Enden des Balkens auf zwei entgegengesetzten Seitenflächen desselben liegen.

11. Vorrichtung nach Anspruch 10, enthaltend zwei weitere biegeelastische Elemente, die im Wesentlichen geradlinig (68a, 70a) sind und jeweils am anderen Ende des Balkens (23) auf den beiden entgegengesetzten Seitenflächen desselben liegen.

12. Vorrichtung nach Anspruch 5, enthaltend zumindest zwei Dehnungsmessstreifen (122, 124, 126, 128), wobei zumindest einer der Dehnungsmessstreifen (122, 124) biegeelastisch ist und das biegeelastische Element aus dem Dehnungsmessstreifen besteht, der biegeelastisch ausgeführt ist.

## Claims

1. A resonant device, with piezoresistive detection, the device including:
- a support (14) having a roughly flat surface,
- a resonator (16) which is suspended from the support, and able to move parallel to the plane of the surface of the support,
- means (17) of actuating the resonator, and
- means (18) for detecting the displacement of the resonator, including at least one piezoresistive strain gauge (20; 20, 40; 56, 58; 72, 72a, 74, 74a; 94, 96, 98, 100; 122, 124, 126, 128) which is suspended from the support,
further comprising at least one elastic element (22; 22, 44; 22, 46; 68, 68a, 70, 70a; 90, 92; 122, 124) different from said piezoresistive strain gauge, through which the resonator is anchored to the support, and wherein the resonator and the elastic element comprise a material able to conduct an electric current,
**characterized in that** the element is flexurally elastic, to enable the threshold at which a non-linear regime of displacement of the resonator appears to be raised.

2. A device according to claim 1, in which the elastic element is roughly rectilinear and the ratio of its length to its width is greater than 5.

3. A device according to claim 2, in which the ratio is greater than 10.

4. A device according to any one of claims 1 to 3, in which the piezoresistive strain gauge includes a stack including at least one piezoresistive material.

5. A device according to any one of claims 1 to 4, in which the strain gauge and the elastic element are roughly rectilinear, and are not extensions of one another.

6. A device according to claim 5, in which the resonator is beam-shaped (23) and in which the strain gauge (20) and the elastic element (22) are located respectively on two opposite lateral faces of the beam.

7. A device according to claim 5, including two roughly rectilinear strain gauges (20, 40), in which the resonator is beam-shaped (23), the two strain gauges are located respectively as extensions of one another, on two opposite lateral faces of the beam, and the elastic element (22) is located on one of the lateral faces.

8. A device according to claim 5, in which the resonator is beam-shaped (23) and the elastic element (22; 22, 46) is located at one end of the beam, and forms with the latter an angle greater than or equal to zero, and less than 90°.

9. A device according to claim 5, including two roughly rectilinear strain gauges (56, 58), in which the resonator has the shape of a tuning fork, with two roughly parallel beams (50, 52) and an elastic connection (54) between the two beams, the elastic element (22) is located at the elastic connection, and the two strain gauges are respectively located as extensions of one another, on both beams of the tuning fork.

10. A device according to claim 5, including two flexurally elastic elements, which are roughly rectilinear (68, 70), in which the resonator is beam-shaped (23), both ends of the beam are capable of being displaced parallel to the plane of the surface of the support (14), and the two elastic elements are respectively located at one of the ends of the beam, on two opposite lateral faces of it.

11. A device according to claim 10, including two other flexurally elastic elements, which are roughly rectilinear (68a, 70a) and are located respectively at the other end of the beam (23), on the two opposite lateral faces of it.

12. A device according to claim 5, including at least two strain gauges (122, 124, 126, 128), in which at least one of the strain gauges (122, 124) is flexurally elastic, and the flexurally elastic element is constituted by the strain gauge which is flexurally elastic.
